# EUROPEAN PATENT APPLICATION

(11) **EP 4 651 652 A1**
(43) Date of publication of application: **19.11.2025**
(21) Application number: 25176641.6
(22) Date of filing: 15.05.2025
(51) Int. Cl.: H05K 7/14

(54) **APPARATUS AND SYSTEM FOR RACK CABLING**

(30) Priority: 17.05.2024 US 202418667703
(71) Applicant: Google LLC, Mountain View, CA 94043 (US)
(72) Inventor: EVANS, Dave Anthony, Mountain View, California, 94043 (US); PANGA, Avinash, Mountain View, California, 94043 (US)
(74) Representative: Betten & Resch

(57) **Abstract**

The present disclosure is generally directed to a cable manifold and a system for rack cabling. A cable manifold includes a base surface, a plurality of sections, and one or more openings. Each of the plurality of sections comprises a respective plurality of sides extending transverse from the base surface, wherein each section shares one or more sides with at least one adjacent section The one or more openings extend through the base surface. One or more sections of the plurality of sections comprises a respective opening of the one or more openings configured to house a cable connector connected to a server tray removably coupled to the cable manifold such that when the cable manifold is removed from the server tray each cable connector housed by the plurality of openings are simultaneously removed from the server tray.

## Description

### BACKGROUND

Cable management is an important design factor for datacenters when considering efficiency, safety, and organization. Proper cable management reduces the likelihood of human error, overheating, and other hazards. Automated server handling has begun to be implemented in data centers operating at hyperscale. Currently, datacenter cables are arranged for human use and hand tooling has been developed to assist manual operators with plugging, removing, and arranging cables. Cable management racks are used to bundle and secure cables and prevent tangling and maintain order. Typically, cables and connectors are dangling from the racks and are not staged in consistent locations for an automated server handling system to handle accurately and effectively.

### BRIEF SUMMARY

Aspects of the disclosure are related to a cable manifold having one or more openings configured to house cable connectors connected to a server tray in a fixed position relative to the manifold. The cable connectors are simultaneously removed from the server tray when the manifold is removed from the server tray. The cable connectors remain in the fixed position along the manifold during removal for easy reinsertion. The cable manifold allows for ease of insertion and removal by a robot directed using a vision system, over approaches in which each cable connector is individually removed from a target cable port of a server tray.

One aspect of the disclosure is directed to a cable manifold comprising a base surface, a plurality of sections, and one or more openings extending through the base surface. Each of the plurality of sections comprises a respective plurality of sides extending transverse from the base surface, wherein each section shares one or more sides with at least one adjacent section. One or more sections of the plurality of sections comprises a respective opening of the one or more openings configured to house a cable connector connected to a server tray removably coupled to the cable manifold such that when the cable manifold is removed from the server tray each cable connector housed by the one or more openings are simultaneously removed from the server tray.

The cable manifold may further comprise at least one fiducial mark.

The cable manifold may further comprise a respective first flap and a respective second flap extending transverse from the base surface at a respective first edge and a respective second edge of a respective opening of each of the one or more sections.

The respective first edge of the respective opening extends from at least one respective side of a respective section of the plurality of sections. The respective first flap and the respective second flap at least partially form a securing mechanism configured to hold a cable connector in a fixed position relative to the cable manifold. The securing mechanism includes a first angled surface on the respective first flap and a second angled surface on the respective second flap, the first and second angled surfaces having a width that tapers from a respective first end of the first and second angled surfaces to a respective second end of the first and second angled surfaces, the respective second end of the first and second angled surfaces is configured to secure the cable connector.

The cable manifold may further comprise a cable holder extending transverse from the base surface within a section of the plurality of sections and comprising a plurality of openings extending through the cable holder. The plurality of openings of the cable holder are configured to hold each cable of each cable connector relative to the cable manifold.

The cable manifold may further comprise the base surface having a width and a height such that the cable manifold extends across a side of the server tray.

The cable manifold may further comprise a first end surface extending transverse from the base surface, wherein the first end surface corresponds to a first side of one of the plurality of sections. A second end surface may extend transverse from the base surface, wherein the second end surface corresponds to a second side of the plurality of sections. A first protrusion may extend transverse from the first end surface and a second protrusion may extend transverse from the second end surface.

Another aspect of the disclosure is directed to a system for rack cabling comprising a server rack; a plurality of server trays in the server rack; and a cable manifold removably coupled to a side of at least one server tray of the plurality of server trays within the server rack, the cable manifold including a plurality of sections, wherein one or more sections of the plurality of sections includes a respective opening housing a respective cable connector. The cable manifold is removably coupled to the cable manifold such that when the cable manifold is removed from a server tray of the plurality of server trays each cable connector housed by the respective opening is simultaneously removed from the server tray and when the cable manifold is inserted along the server tray each cable connector housed by the respective opening is simultaneously inserted into the server tray.

The respective opening of the one or more sections comprises a first flap and a second flap configured to hold the cable connector in a fixed position relative to the cable manifold during removal and insertion of the cable manifold. The first and second flap include a first and a second edge of the first and second flap that are configured to latch and unlatch the cable connector to the cable manifold, the first and the second edge of the first and second flap extending transversely from the first and second flap. The respective opening aligns with a port of a server tray of the plurality of server trays when the cable manifold is removably coupled to the side of the server tray.

The system may further comprise a server rack comprising a first column and a second column adjacent to the first column. The server trays of the plurality of server trays are stacked in the first column and the second column.

The system may further comprise a fiducial mark on the cable manifold.

The system may further comprise a robot configured to insert and remove the cable manifold to and from the server tray. The robot is configured to scan the fiducial mark to identify a cable manifold location on the server tray.

### BRIEF DESCRIPTION OF THE DRAWINGS

Fig. 1 is a front view of a frontside of a server rack having an example manifold, according to aspects of the disclosure.
Fig. 2 is a perspective view of the example manifold of Fig. 1, according to aspects of the disclosure.
Fig. 3 is a perspective view of the example manifold of Fig. 1, according to aspects of the disclosure.
Fig. 4 is a perspective view of the frontside of the server rack of Fig. 1, according to aspects of the disclosure.
Fig. 5 is a perspective view of an opening of the example manifold of Fig. 1, according to aspects of the disclosure.
Fig. 6 is a perspective view of the opening of the example manifold of Fig. 1 housing a cable connector, according to aspects of the disclosure.
Fig. 7 is a perspective view of the example manifold of Fig. 1 engaging a cable management rack, according to aspects of the disclosure.
Fig. 8 is a block diagram of an example system for automated server handling, according to aspects of the disclosure.

### DETAILED DESCRIPTION

Aspects of the disclosure are directed to a manifold for managing cables for a server tray on a server rack. A manifold can house cable connectors on a side of a server, e.g., the frontside of the server tray, or the side of the server tray facing an aisle or empty space between the server racks. A plurality of manifolds can be used in combination on the side of the server rack to hold the cables for automated server handling, including the extraction and the insertion of the servers and/or of server trays into the rack. Each manifold fixes the cable connectors in a consistent position on the frontside of the server for ease of accessibility during server handling, for example, for mobile robots configured to insert the manifold along the server tray and remove the manifold from the server tray.

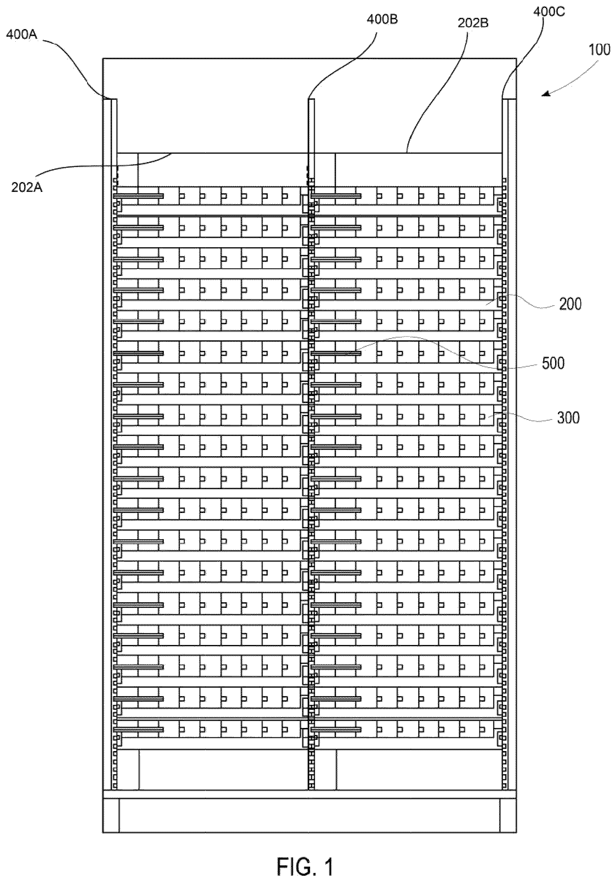

Fig. 1 is a front view of a frontside of a server rack 100 having an example manifold 300, according to aspects of the disclosure. As shown in Fig. 1, a server tray 200 in a server rack 100 can have a corresponding manifold 300 housing cables for the server tray 200. Although a single server tray 200 is labeled in Fig. 1, multiple server trays are shown in the rack 100 but are not labeled, for clarity. Each server tray can be the same as the server tray 200 or be a different type of server tray housed in the rack 100. Similarly, although a single manifold 300 is labeled in Fig. 1, multiple manifolds are depicted, each manifold can correspond to a respective server tray on the rack 100 and be implemented like the manifold 300 or other examples described herein.

Server rack 100 can be one of multiple server racks housing the server tray in a physical location, such as a data center. The server rack 100 can include one or more server trays, e.g., including the server tray 200. The servers in the rack 100 may be stacked on top of each other in a first column 202A and a second column 202B of server trays adjacent to the first column 202A. In some examples, the server rack 100 can include more or fewer columns of server trays.

The manifold 300 can be positioned on a side of the server tray 200 from which cables, e.g., power cables, I/O cables, networking cables, are plugged into the server tray 200. For example, the manifold 300 can be positioned on the frontside of the server tray 200. The manifold 300 can extend across the full length of the server tray 200. In some examples, the manifold 300 may have a smaller height than the server tray 200 and does not extend the full height of the server tray 200 as shown in Fig 1. However, the height of the manifold 300 is not limited as such and the height of the manifold may extend to the full height of the server tray 200.

The manifold 300 may be removably coupled to cable management racks 400B and 400C attached to the server rack 100 on both ends of the manifold 300. The manifold may also be removably coupled to the server tray 200. Cable management rack 400A is also shown coupled to the first column 202A of the server rack 100. The server rack 100 can have more than one cable management rack, e.g., cable management rack 400B and 400C, as to engage both ends of each manifold 300. In some examples, the cable management racks can be built as part of the server rack 100, e.g., machined or welded to the rack 100.

The manifold 300 positions the cable connectors to promote accessibility during an automated server handling process. A mobile robot can be configured for server handling, for example to locate and manipulate server devices on server racks of a datacenter, to perform upgrades, maintenance, replacements, and so on. For example, the mobile robot can use image or video processing to determine manifold positioning on a server tray and then remove the manifold from the server tray to prepare the server tray for extraction. For example, the manifold is positioned over external facing ports of a server tray, aligning openings in the manifold with corresponding ports of the server. Each cable connector is given a fixed location along the manifold. The manifold holds the cable connectors in a fixed location relative to the manifold which allows the mobile robot to easily remove and reinsert cable connectors simultaneously into ports along a server tray.

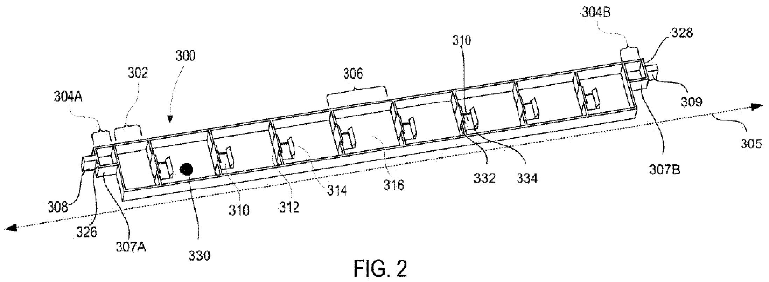

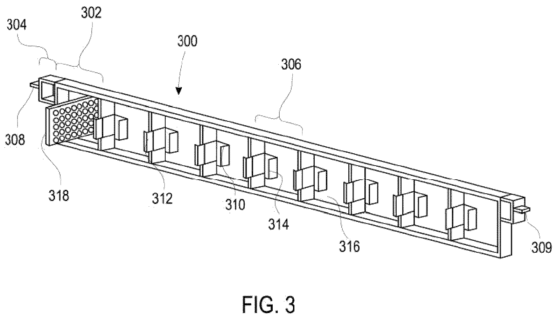

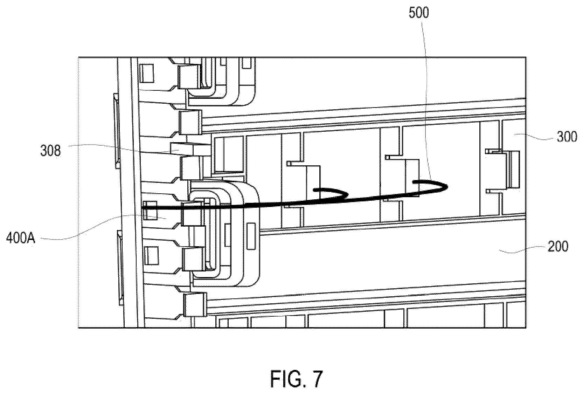

Figs. 2 and 3 are a perspective view of the example manifold 300 of Fig. 1, according to aspects of the disclosure. As shown in Fig. 2, the manifold 300 may include a fiducial mark 330 that acts as a reference for a mobile robot configured to insert or remove the manifold and the connectors to the ports of the server tray, for example through a gripper or other manifold manipulation apparatus implemented as part of the robot. The fiducial mark 330 may be one of multiple fiducial marks, which may be the same kind of mark or vary in design, shape, size, color, etc. The fiducial mark 330 can be placed on the manifold 300 such that the robot can scan, for example, using a camera, the fiducial mark and align itself with the manifold, for example using a camera or other sensing apparatus. In some examples, different marks can correspond to different openings in the manifold 300 for different types of cable connectors that can be plugged into the server tray 200. In some examples, the fiducial mark 330 can be used by a mobile robot or other sensing device to classify the opening corresponding to the fiducial mark, e.g., opening 310, As described herein with reference to Fig. 7, a mobile robot can be configured to process image data containing the marks to identify the manifold position relative to the server tray.

As shown in Fig. 2, the manifold 300 can be separated into a plurality of sections, e.g., end sections, such as opened section 306, un-opened sections, such as un-opened section 302, and opened sections, such as opened section 306. In some examples, the sections may be rectangular. Each section of the manifold 300 includes a base surface 316 with four sides transversely extending from the base surface. The size, shape, and number of sides of the sections can vary, for example for different manifolds and/or depending on the location along the manifold 300. Sections of the manifold can share one or more sides with another adjacent section.

The manifold 300 further includes one or more openings, e.g., opening 310, extending through the base surface 316. One or more sections, e.g., opened sections such as opened section 306, can include an opening, such as the opening 310. The sections allow for guiding cable connectors through the opening 310 of the manifold 300 into the correct port of the server. A first flap 312 and a second flap 314 extend transversely from the base surface 316 at a first edge 332 and a second edge 334 of the respective opening 310. The first and second flaps are configured to hold the cable connectors in a fixed position relative to the manifold during removal and insertion. The first and second flaps at least partially form a securing mechanism configured to hold the cable connectors in a fixed position. To that end, the manifold enables better insertion and removal of the cable connectors from the server tray. This is at least because the manifold provides a target for mobile robots when inserting or removing cable connectors and holds the cable connectors in a fixed position, which allows for simultaneously insertion and removal of the cable connectors. While not individually labeled in Fig. 2 the manifold may include multiple end sections 304, un-opened sections 302, opened sections 306, openings 310, and first and second flaps 312, 314. These features and their additional counterparts described below may be referenced as multiple or singular.

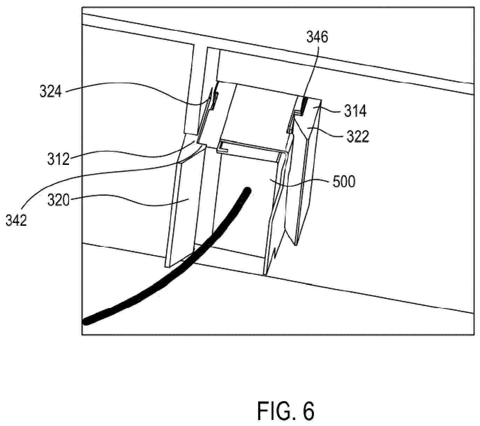

The manifold 300 further includes end sections 304A, 304B on either end of a longitudinal axis 305 through the manifold 300. The end sections 304A, 304B may have a height shorter than the sections of the manifold 300. The end sections have edges, e.g., a bottom edge 307A and a bottom edge 307B, that may not extend past a longitudinal axis of the manifold 300 along the base surface 316. The end sections 304A, 304B may be uniform on each side of the manifold 300 and may not include an opening 310. As shown in Fig. 3 and Fig. 6, the manifold 300 further includes a first protrusion 308 and a second protrusion 309 on sides of the end sections 304A and 304B, respectively.

The manifold 300 includes a first end surface 326 and a second end surface 328, both extending transversely from the base surface 316. The first and second end surfaces 326, 328 correspond to a side of each end section 304A, 304B. In some examples, corresponding to a side of each end section means, e.g., that the end surface may be a side of the plurality of sections. The first and second protrusions 308, 309 extend transversely from the first and second end surfaces 326, 328. In some examples, the protrusions 308, 309 may be rectangular in shape and extend from longitudinal axis 305 of the bottom edges 307A, 307B of the end sections 304A, 304B. The protrusions 308, 309 secure the manifold 300 to the cable management racks 400B, 400C on both ends of the manifold 300, for example by slotting the protrusions 308, 309 into openings of the cable management racks.

As shown in Fig. 2, adjacent to the end section 304A, on one side of the manifold 300 there may be an un-opened section 302. As shown in Fig. 3, the un-opened section 302 includes a cable holder 318 extending perpendicularly from the base surface 316 of the manifold 300. In other examples, the manifold 300 may include a cable holder 318 extending transverse from the base surface 316 within a section of the manifold 300. The cable holder 318 may include a plurality of openings 323 extending through the cable holder 318. In some examples, the cable holder 318 includes multiple cylindrical openings. The cable holder is configured to hold each cable of each cable connector in a fixed position relative to the manifold.

Cables connected to the server tray 200 can be strung through an opening of the plurality of openings 323 of the cable holder 318, each opening sized to allow for a cable to pass through. The cable holder 318 is configured to hold the cables relative to the manifold. In some examples, when the cable connectors are simultaneously unlatched and disconnected from the server tray 200, the cable holder 318 holds the cables in an organized manner with reference to the manifold 300. The cable connectors are reconnected to the server tray while the manifold is holding the cables in an organized manner expediting the reconnection of the cables to the new server tray. For example, the cable holder 318 holds the cables in a fixed position, allowing the cables to rest in a more predictable manner to assist re-inserting the cables later.

Adjacent to the un-opened section 302, are multiple opened sections, e.g., opened section 306. Each opened section contains a single opening, e.g., an opening 310 for opened section 306. As shown in Figs. 2-4 the opened sections are positioned adjacent to each other, each opened section sharing at least one side with another opened section. The opened section 306 includes the opening 310, which may be positioned along an edge of the base surface 316 of the section. The opening 310 extends from the first edge 332 to the second edge 334. The first edge 332 of the opening 310 may extend from a side of a section of the manifold 300. The opening 310 can be positioned on the shorter side of the opened section 306, in examples in which the opened section is rectangular. A midline of the opening 310 may be located slightly below the longitudinal axis 305 of the base surface 316 of the manifold 300. Each opening along the manifold 300 may be positioned in the same location of each opened section, for example as shown with opening 310 and opened section 306. In some examples, the opening 310 may be rectangular in shape and each opening along the manifold 300 is uniform in size and shape. In other examples, the openings may vary in shape and size.

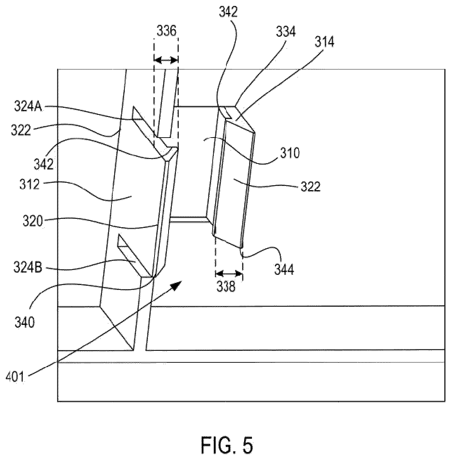

Fig. 5 is a perspective view of a security mechanism 401 of the example manifold 300 of Fig. 1, according to aspects of the disclosure. Each opening of the manifold 300 is used to organize and hold cable connectors in a fixed position relative to the server tray 200. As shown in Figs. 5 and 6, the opening 310 includes a securing mechanism 401 configured to hold the cable connectors in a fixed position as the manifold 300 is removed from the server tray 200. The cable connectors remain fixed in each opening 310 of the manifold 300 as the manifold is removed from the server tray 200. Removing the manifold 300 from the server tray 200 simultaneously removes each cable connector that is housed by each opening 310 from the server tray 200. Each cable connector is held in place along the manifold 300 by each securing mechanism 401.

Fig. 5 is a perspective view of the opening 310 of the example manifold 300 of Fig. 1 housing a cable connector, according to aspects of the disclosure. The securing mechanism 401 may act as a latching and unlatching mechanism that works with a cable connector 500 to secure a cable to the manifold 300. The latching mechanism 401 may include the first flap 312 extending transversely from the first edge 332 of the opening 310 and the second flap 314 extending transversely from the second edge 334 of the opening 310. The second flap 314 may extend from the base surface 316 of the manifold 300 parallel to the first flap 312. The first flap 312 may include a first angled surface 320 and the second flap 314 may include a second angled surface 322. The first and second angled surfaces 320, 322 have a first width 336 and a second width 338 that taper from first ends 340, 344 of the first and second angled surfaces 320, 322 to second ends 342, 346 of the first and second angled surfaces 320, 322.

The second ends 342, 346 are configured to secure the cable connector 500, with each end engaging an edge of the cable connector to lock it into place. On either side of the first flap 312 there may be slots 324 along the side of the manifold 300. The first end 340 of the first angled surface 320 of the first flap 312 can extend past a top side of the manifold 300, e.g., the side facing away from a server rack when the manifold is mounted to a rack. The first end 340 is configured to secure an outer edge of the cable connector 500. The second flap 314 may be shorter in length than the first flap 312 and may not extend past the top side of the manifold 300.

The manifold 300 can be made from a flexible material such as a plastic that allows the flaps 312, 314 to engage or disengage from the cable connectors by snapping in and out of place. The dimensions of the openings align with the dimensions of the cable connectors, such as pluggable connectors, including quad small form factor pluggable (QSFP) connectors. The connectors include features that can mount or snap into the manifold openings.

Fig. 7 is a perspective view of the example manifold of Fig. 1 engaging a cable management rack, according to aspects of the disclosure. As shown in Fig. 1, the server rack 100 may include separate cable management racks 400A-400C having a plurality of brackets extending from the rack. The manifold 300 rests on a top surface of a bracket protruding from the cable management racks 400A-400C. In addition, the cable management racks provide a second organization feature by holding the length of the cables along the side of the server rack.

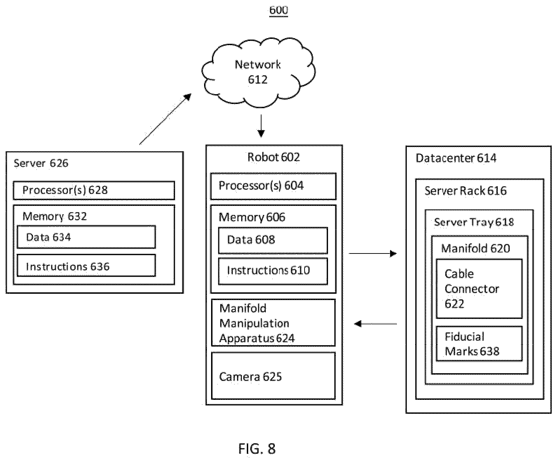

Fig. 8 is a block diagram of an example system 600 for automated server handling. Aspects of the disclosure provide for a system 600 of rack cabling for automated server handling. Fig. 8 illustrates an example system 600 in which the features described above may be implemented. It should not be considered limiting the scope of the disclosure or usefulness of the features described herein. In this example, the system 600 may include a robot 602, a server 626, a network 612, and a datacenter 614.

The datacenter 614 includes a server rack 616. In some examples, the datacenter 614 may include a plurality of server racks. The server rack 616 may include a server tray 618 having a manifold 620, or a plurality of server trays each having a respective manifold. Manifold 620 may be implemented as described herein with reference to manifold 300. The manifold 620 may house cable connectors 622. The manifold 620 is configured to hold the cable connectors 622 extending from ports of the server tray 618 in a fixed position relative to the manifold 620, for example as described above. The manifold 620 holds the cable connectors 622 in a fixed position which allows the robot 602 to simultaneously insert and remove each cable connector housed by the manifold when the manifold is inserted or removed from the server tray 618. The manifold 620 may also include fiducial marks 638.The fiducial marks 638 can assist the robot in identifying the respective position of the manifold relative to the server tray 618.

In further detail, the manifold 620 may include one or more fiducial marks 638. The fiducial mark 638 may act as a reference point for the mobile robot 602. In some examples, the robot 602 may scan the manifold 620 to identify the location of the fiducial mark 638 to determine the position of the manifold 620 or a manifold location. Once the robot has determined the position of the manifold, the robot aligns itself with the manifold within a margin of error necessary for proper manifold extraction, server tray extraction, server tray insertion, and manifold reinsertion. The robot can remove and insert each manifold 620 using a manifold manipulation apparatus 624, such as gripping mechanism, a claw, a suction cap, a robotic arm, or the like. Each cable connector remains housed in a single opening in a single section as the manifold is removed and inserted to provide ease of cable insertion and removal by the robot during automated server handling.

The robot 602 may include a mobile robot used to complete an automated server handling process which includes disconnecting and reconnecting the cable connectors 622 in the server tray 618 by removing and reinserting the manifold 620 using a manifold manipulation apparatus 624. The robot 602 may include one or more processors 604 and a memory 606. The memory 606 of the robot 602 includes data 608 and instructions 610. The data 608 may include a machine learning program or a visual system that can create a 3D visualization of a datacenter server rack. The instructions 610 may include an external database of coordinates of each server rack 616 in the datacenter 614 or readings from the fiducial mark 638 on the manifold 620. The instructions 610 allow the robot 602 to navigate the datacenter 614 to complete automated server handling. The data 608 allows the robot 602 to identify which server tray 618 in each server rack 616 of the datacenter 614 requires maintenance. The data 608 may also include signals from the fiducial mark 638 on the manifold 620 which allow the robot 602 to identify the position of the manifold 620.

Memory 606 of the robot 602 can store information accessible by the one or more processors 604, including instructions 610 that can be executed by the one or more processors 604. Memory 606 can also include data 608 that can be retrieved, manipulated, or stored by the processor. The memory 606 can be of any non-transitory type capable of storing information accessible by the processor, such as a hard-drive, memory card, read-only memory ("ROM"), random access memory ("RAM"), optical disks, as well as other write-capable and read-only memories. Memory 606 may store information that is accessible by the processors 604, including instructions 610 that may be executed by processors 604, and data 608.

The instructions 610 can be any set of instructions to be executed directly, such as machine code, or indirectly, such as scripts, by the one or more processors. In that regard, the terms "instructions," "application," "steps," and "programs" can be used interchangeably herein. The instructions can be stored in object code format for direct processing by a processor, or in any other computing device language including scripts or collections of independent source code modules that are interpreted on demand or compiled in advance.

Data 608 may be retrieved, stored, or modified by the one or more processors 604 in accordance with the instructions 610. For instance, although the subject matter described herein is not limited by any particular data structure, the data can be stored in computer registers, in a relational database as a table having many different fields and records, or XML documents. The data can also be formatted in any computing device-readable format such as, but not limited to, binary values, ASCII, or Unicode. Moreover, the data can include any information sufficient to identify the relevant information, such as numbers, descriptive text, proprietary codes, pointers, references to data stored in other memories such as at other network locations, or information that is used by a function to calculate the relevant data.

The one or more processors 604 may include any conventional processor, such as a CPU or microprocessor. Alternatively, the processor can be a dedicated component such as an ASIC or other hardware-based processor. Although not necessary, the server 626 may include computing devices that include specialized hardware components to perform specific computing functions faster or more efficiently.

Although Fig. 8 functionally illustrates the processor, memory, and other elements of the robot 602 as being within the same respective blocks, it will be understood by those of ordinary skill in the art that the processor or memory may actually include multiple processors or memories that may or may not be stored within the same physical housing. Similarly, the memory may be a hard drive or other storage media located in a housing different from that of the robot 602. Accordingly, references to a processor or server will be understood to include references to a collection of processors, servers, or memories that may or may not operate in parallel.

System 600 further includes the server 626 utilized to provide data 634 and instructions 636 to the robot 602 through the network 612. The server 626 may include a processor 628 and a memory 632. The memory 632 may include data 634 and instructions 636. The data 634 may include a database of relative coordinates of each server rack 616 in the datacenter 614. The instructions 636 may include offset calculations from the reference points used to calculate relative coordinates of each server rack 616.

Processor 628, memory 632, data 634, and instructions 636 of the server 626 can be structurally and functionally similar to above disclosed processors 604, memory 606, data 608, and instructions 610 of the robot 602.

As shown in Fig. 8, the robot 602 may be intended for use by a respective user, and have all of the components normally used in connection with a computing device including one or more processors (e.g., a central processing unit (CPU)), memory (e.g., RAM and internal hard drives) storing data and instructions, an output, such as a display (e.g., a monitor having a screen, a touch-screen, a projector, a television, or other device such as a smart watch display that is operable to display information), and user input devices (e.g., a mouse, keyboard, touchscreen or microphone). The robot 602 may also include a camera 625 for recording video streams, speakers, a network interface device, and all of the components used for connecting these elements to one another. The robot 602 may be capable of wirelessly exchanging or obtaining data over the network 612.

Although the robot 602 may include a full-sized computing device, it may alternatively include mobile computing devices capable of wirelessly exchanging data with a server over a network such as the Internet. By way of example only, robot 602 may include a mobile phone or a device such as a wireless-enabled PDA, a tablet PC, a netbook, a smart watch, a head-mounted computing system, or any other device that is capable of obtaining information via the Internet. As an example, robot 602 may receive user input from a user input device, such as a keyboard, a keypad, microphone, using visual signals with a camera, or a touch screen.

Referring back to Fig. 8, the robot 602 and the server 626 can be at various nodes of a network 612 and capable of directly and indirectly communicating with other nodes of network 612. Although one robot 602 and one server 626 is depicted in Fig. 8, it should be appreciated that a system can include one or more devices or servers, with each device or server being at a different node of network 612. The network 612 and intervening nodes described herein can be interconnected using various protocols and systems, such that the network can be part of the Internet, World Wide Web, specific intranets, wide area networks, or local networks. The network 612 can utilize standard communications protocols, such as WiFi, Bluetooth, 4G, 5G, or any other manner of transmission or protocol.

In one example, system 600 may include one or more servers, e.g., server 626 having one or more computing devices, e.g., a server farm, which is configured to exchange information with different devices of a network for the purpose of receiving, processing, and transmitting the data to and from other computing devices. For instance, the server 626 may be a web server that is capable of communicating with the one or more robots, such as the robot 602, using the network 612. The processes and logic flows described herein can be performed by one or more computers executing one or more computer programs to perform functions by operating on input data and generating output data. The processes and logic flows can also be performed by special purpose logic circuitry, or by a combination of special purpose logic circuitry and one or more computers.

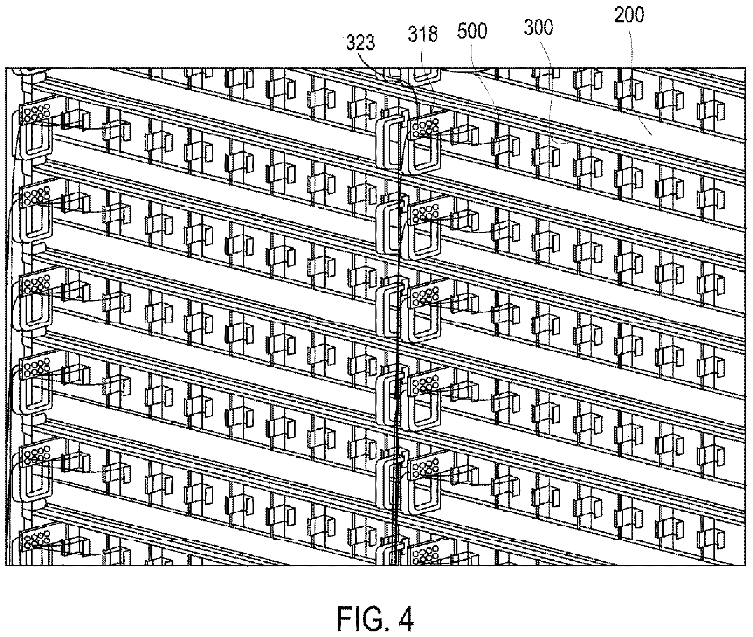

In further detail, in some examples, system 600 may also include a manifold including a cable holder 318, for example as shown and described with reference to Fig. 4. The cable holder 318 extends from the base surface 316 of the manifold 300. The cable holder 318 includes a plurality of openings. The number of openings on the cable holder 318 can be equal to the number of openings 310 along the manifold 300. Each cable connected to the server tray may first be strung through an opening on the cable holder. In some examples, the cable holder is removably coupled to a section of the manifold. The cable holder includes a plurality of cylindrical openings extending through the cable holder configured to each hold a cable. Thus, cable organization is maintained during server extraction and insertion.

The robot 602 may remove the manifold from the server tray and the cable connectors will remain fixed with their corresponding opening in the manifold and the cables will remain fixed in the corresponding opening in the cable holder as the server tray is removed. Once a new server is replaced within the server rack, the manifold can easily be reinserted along the new server tray and the cable connectors reinserted into the server tray. The mobile robot can easily reattach each cable connector in their corresponding opening along the server tray simultaneously with replacing the manifold as each cable connector is in a fixed position along the manifold.

As shown in Fig. 7, the system 600 can further include at least one cable management rack, e.g., like the cable management racks 400A-C as shown and described with reference to Fig. 1. The cable management rack provides a second organization feature by holding the length of the cables along the side of the server rack. The cables flow from the cable holder on the manifold to the cable management rack and are secured behind each individual bracket.

In some examples, the term "configured" is used herein in connection with systems and computer program components. For a system of one or more computers to be configured to perform particular operations or actions means that the system has installed on IT software, firmware, hardware, or a combination thereof that cause the system to perform the operations or actions. For one or more computer programs to be configured to perform particular operations or actions means that the one or more programs include instructions that, when executed by one or more data processing apparatus, cause the apparatus to perform the operations or actions.

Although the implementations disclosed herein have been described with reference to particular features, it is to be understood that these features are merely illustrative of the principles and applications of the present implementations. It is therefore to be understood that numerous modifications, including changes in the sizes of the various features described herein, may be made to the illustrative implementations and that other arrangements may be devised without departing from the spirit and scope of the present implementations. In this regard, the present implementations encompass numerous additional features in addition to those specific features set forth in the paragraphs above.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as "such as," "including" and the like, should not be interpreted as limiting the subject matter of the claims to the specific examples; rather, the examples are intended to illustrate only one of many examples. Further, the same reference numbers in different drawings can identify the same or similar elements.

## Claims

1. A cable manifold, comprising:
a base surface;
a plurality of sections, wherein each of the plurality of sections comprises a respective plurality of sides extending transverse from the base surface, wherein each section shares one or more sides with at least one adjacent section; and
one or more openings extending through the base surface,
wherein one or more sections of the plurality of sections comprises a respective opening of the one or more openings configured to house a cable connector connected to a server tray removably coupled to the cable manifold such that when the cable manifold is removed from the server tray each cable connector housed by the one or more openings are simultaneously removed from the server tray.

2. The cable manifold of claim 1, further comprising at least one fiducial mark.

3. The cable manifold of claim 1 or claim 2, further comprising a respective first flap and a respective second flap extending transverse from the base surface at a respective first edge and a respective second edge of a respective opening of each of the one or more sections.

4. The cable manifold of claim 3, wherein the respective first edge of the respective opening extends from at least one respective side of a respective section of the plurality of sections.

5. The cable manifold of claim 3 or claim 4, wherein the respective first flap and the respective second flap at least partially form a securing mechanism configured to hold a cable connector in a fixed position relative to the cable manifold.

6. The cable manifold of claim 5, wherein the securing mechanism includes a first angled surface on the respective first flap and a second angled surface on the respective second flap, the first and second angled surfaces having a width that tapers from a respective first end of the first and second angled surfaces to a respective second end of the first and second angled surfaces, the respective second end of the first and second angled surfaces is configured to secure the cable connector.

7. The cable manifold of any one of claims 1 to 6, further comprising a cable holder extending transverse from the base surface within a section of the plurality of sections and comprising a plurality of openings extending through the cable holder; and
wherein optionally the plurality of openings of the cable holder are configured to hold each cable of each cable connector relative to the cable manifold.

8. The cable manifold of any one of claims 1 to 7, wherein the base surface has a width and a height such that the cable manifold extends across a side of the server tray; and/or
wherein the cable manifold further comprises:
a first end surface extending transverse from the base surface, wherein the first end surface corresponds to a first side of one of the plurality of sections;
a second end surface extending transverse from the base surface, wherein the second end surface corresponds to a second side of the plurality of sections;
a first protrusion extending transverse from the first end surface; and
a second protrusion extending transverse from the second end surface.

9. A system for rack cabling, comprising:
a server rack;
a plurality of server trays in the server rack; and
a cable manifold removably coupled to a side of at least one server tray of the plurality of server trays within the server rack, the cable manifold including a plurality of sections, wherein one or more sections of the plurality of sections includes a respective opening housing a respective cable connector,
wherein the cable manifold is removably coupled to the cable manifold such that when the cable manifold is removed from a server tray of the plurality of server trays each cable connector housed by the respective opening is simultaneously removed from the server tray and when the cable manifold is inserted along the server tray each cable connector housed by the respective opening is simultaneously inserted into the server tray.

10. The system of claim 9, wherein the respective opening of the one or more sections comprises a first flap and a second flap configured to hold the cable connector in a fixed position relative to the cable manifold during removal and insertion of the cable manifold.

11. The system of claim 10, wherein the first and second flap include a first and a second edge of the first and second flap that are configured to latch and unlatch the cable connector to the cable manifold, the first and the second edge of the first and second flap extending transversely from the first and second flap; and/or
wherein the respective opening aligns with a port of a server tray of the plurality of server trays when the cable manifold is removably coupled to the side of the server tray.

12. The system of any one of claims 9 to 11,
wherein the server rack comprises a first column and a second column adjacent to the first column, and
wherein server trays of the plurality of server trays are stacked in the first column and the second column.

13. The system of any one of claims 9 to 12, further comprising a fiducial mark on the cable manifold.

14. The system of claim 13, further comprising a robot configured to insert and remove the cable manifold to and from the server tray; and
wherein the robot is optionally configured to scan the fiducial mark to identify a cable manifold location on the server tray.

15. The system of any one of claims 9 to 14, further comprising a cable management rack, the cable management rack connecting the cable manifold to the server rack; and/or
further comprising a cable holder removably coupled to a section of the plurality of sections, the cable holder including a plurality of cylindrical openings extending through the cable holder.
